# FASCICULE DE BREVET EUROPEEN

(11) **EP 1 630 262 B1**
(45) Date de publication et mention de la délivrance du brevet: **12.05.2010**
(21) Numéro de dépôt: 05107659.4
(22) Date de dépôt: 19.08.2005
(51) Int. Cl.: C30B 29/52, B23K 26/34, F01D 5/00

(54) **Procédé de rechargement d'une pièce métallique monocristalline ou à solidification dirigée**
Verfahren zum Wiederaufbauen eines Bauteiles aus einkristallinem oder gerichtet erstarrtem Metall
Process for rebuilding a single crystal or directionally solidified metallic article

(30) Priorité: 30.08.2004 FR 0451934
(43) Date de publication de la demande: 01.03.2006
(73) Titulaire: SNECMA, 75015 Paris (FR)
(72) Inventeur: Gourbesville, Olivier, 78170, La Celle Saint Cloud (FR); Ferte, Jean-Pierre, 91100, Corbeil Essonnes (FR); Pinto, Eric, 77930, Fleury en Bière (FR); Braillard, Frédéric, 86100, Chatellerault (FR)
(74) Mandataire: David, Daniel

(56) Documents cités:
- EP-A- 0 740 976
- EP-A- 1 340 583
- EP-A- 1 424 158
- US-A- 5 122 632
- US-A- 6 024 792
- US-A1- 2003 213 427
- US-A1- 2004 112 280

## Description

L'invention concerne un procédé de rechargement d'une pièce métallique monocristalline ou à solidification dirigée, d'épaisseur inférieure à 2 mm.

Les aubes de turbines sont généralement constituées d'un alliage monocristallin ou à solidification dirigée. En raison des conditions locales de fonctionnement et des frottements qu'elles subissent sur les parois du stator par rapport auquel elles sont mises en rotation, il est fréquent que leur portion d'extrémité externe s'use. Il est donc nécessaire de "recharger" leur portion d'extrémité, c'est-à-dire de reconstruire une paroi à partir du sommet usé de l'aube.

Par le brevet US 6, 024, 792, on connaît un procédé de rechargement de la portion d'extrémité de la paroi d'une pièce monocristalline ou à solidification dirigée. Dans ce dernier, l'extrémité de la pièce est tout d'abord préchauffée, puis soumise à un faisceau laser CO₂ perpendiculaire à sa surface et à un flux de poudre métallique, projeté par une buse latérale selon une direction inclinée par rapport à l'axe du faisceau laser. Ce dernier entraîne la fonte de la poudre et la croissance d'une couche métallique monocristalline ou à solidification dirigée à partir du substrat que constitue la paroi initiale de l'aube. Plusieurs couches sont ainsi construites successivement. La puissance du faisceau laser est réglée de façon à ce que l'on se trouve toujours dans une plage de gradient thermique et de vitesse de solidification dans laquelle la nouvelle couche formée est effectivement de structure monocristalline ou à solidification dirigée, les nouveaux grains croissant de façon colonnaire épitaxiale avec le ou les grains du substrat.

Les documents EP-A-1424158 et EP-A-1340583 enseignent des procédés similaires à celui de US 6024792.

Un tel procédé de rechargement d'une paroi d'une pièce doit être mis en oeuvre avec des paramètres optimisés, la portion de paroi rechargée devant posséder des propriétés mécaniques proches de celles du matériau de base. Or pour une aube de turbomachine, par exemple, l'épaisseur de la paroi est variable, ne serait-ce qu'entre l'extrados ou l'intrados et le bord de fuite. Il faut donc adapter le fonctionnement du dispositif à l'épaisseur de la paroi en cours de procédé.

On n'a pas jusqu'à présent donné de définition précise des paramètres, ni de l'agencement du dispositif, pour un procédé de rechargement homogène épitaxial de la paroi d'une pièce métallique, en fonction de l'épaisseur de cette dernière.

La demanderesse a mené une série d'essais afin de déterminer les conditions optimales de rechargement et a ainsi abouti à l'invention, qui vise à améliorer un procédé de rechargement d'une pièce monocristalline ou à solidification dirigée d'épaisseur inférieure à 2 mm.

A cet effet, l'invention concerne un procédé de rechargement d'une pièce métallique monocristalline ou à solidification dirigée, d'épaisseur inférieure à 2 mm, dans lequel on applique un faisceau laser et un flux de poudre métallique, dont la nature est la même que celle de la pièce métallique, sur la pièce pour fabriquer au moins une couche de métal, monocristalline ou à solidification dirigée, à partir de la pièce, le faisceau laser étant émis à une puissance "P" et se déplaçant le long de la pièce à une vitesse "v", caractérisé par le fait que le faisceau laser et le flux de poudre sont appliqués de façon coaxiale sur la pièce et le rapport P/v est compris :
- pour une épaisseur Wₛ comprise entre 0,2 et 0,6 mm, entre deux portions de courbes croissantes, l'une prenant des valeurs allant de 0,12, de préférence 0,125, à 0,58, de préférence 0,583 W.min.mm⁻¹, l'autre prenant des valeurs allant de 0,25 à 0,84, de préférence 0,833 W.min.mm⁻¹;
- pour une épaisseur Wₛ comprise entre 0,6 et 0,8 mm, entre deux portions de courbes croissantes, l'une prenant des valeurs allant de 0,58, de préférence 0,583, à 0,83, de préférence 0,833 W.min.mm⁻¹, l'autre prenant des valeurs allant de 0,84, de préférence 0,833, à 1,42, de préférence 1,417 W.min.mm⁻¹;
- pour une épaisseur Wₛ comprise entre 0,8 et 1 mm, entre deux portions de courbes croissantes, l'une prenant des valeurs allant de 0,83, de préférence 0,833, à 1,08, de préférence 1,083 W.min.mm⁻¹, l'autre prenant des valeurs allant de 1,42, de préférence 1,417, à 2,05, de préférence 2,042 W.min.mm⁻¹ ;
- pour une épaisseur Wₛ comprise entre 1 et 1,2 mm, entre deux portions de courbes croissantes, l'une prenant des valeurs allant de 1,08, de préférence 1,083, à 1,27, de préférence 1,271 W.min.mm⁻¹, l'autre prenant des valeurs allant de 2,05, de préférence 2,042, à 2,34, de préférence 2,333 W.min.mm⁻¹;
- pour une épaisseur Wₛ comprise entre 1,2 et 1,4 mm, entre deux portions de courbes croissantes, l'une prenant des valeurs allant de 1,27, de préférence 1,271, à 1,33, de préférence 1,333 W.min.mm⁻¹, l'autre prenant des valeurs allant de 2,34, de préférence 2,333, à 2,48, de préférence 2,479 W.min.mm⁻¹;
- pour une épaisseur Wₛ comprise entre 1,4 et 2 mm, entre deux portions de courbes croissantes, l'une constante égale à 1, 33, de préférence 1,333 W.min.mm⁻¹, l'autre prenant des valeurs allant de 2,48, de préférence 2,479, à 2,75 W.min.mm⁻¹.

Ainsi, la demanderesse a découvert qu'il était possible de déterminer une plage de valeurs pour le rapport P/v, qui garantisse un bon fonctionnement du procédé de rechargement.

De préférence, les portions de courbes sont des portions de droites.

Selon un mode de réalisation, avant d'appliquer le flux de poudre, on effectue un préchauffage de la pièce.

De préférence dans ce cas, le préchauffage est effectué par le faisceau laser.

Selon un autre mode de réalisation, l'application du flux de poudre est effectuée sans préchauffage de la pièce.

Selon une forme de réalisation, plusieurs couches de métal étant successivement fabriquées, l'énergie appliquée le long de la pièce à toutes les couches est la même.

Selon une autre forme de réalisation, plusieurs couches de métal étant successivement fabriquées, l'énergie de la première couche est inférieure à l'énergie des couches suivantes.

De préférence, quelle que soit la forme de réalisation choisie, le rapport P/v des couches auxquelles est appliquée la même énergie est égal.

Avantageusement, le faisceau laser est un faisceau laser YAG.

Avantageusement encore, le faisceau laser et la poudre métallique sont appliqués par une buse de projection, comprenant une portion d'extrémité tronconique qui comporte un alésage central de passage du faisceau laser et des canaux, s'étendant dans la paroi de génération de son extrémité tronconique, d'alimentation en poudre.

L'invention s'applique particulièrement à une aube de moteur à turbine à gaz et à une poudre comprenant un alliage monocristallin dit AM1, mais la demanderesse n'entend pas limiter la portée de ses droits à cette application.

L'invention sera mieux comprise à l'aide de la description suivante de la forme de réalisation préférée du procédé de l'invention, en référence aux dessins annexés, sur lesquels :
- la figure 1 représente une vue en coupe schématique de la buse de projection du dispositif de mise en oeuvre de la forme de réalisation préférée du procédé de l'invention ;
- la figure 2 représente une vue en coupe schématique du rechargement d'une aube par la forme de réalisation préférée du procédé de l'invention ;
- la figure 3 représente une courbe de définition de la plage des valeurs admises pour le rapport de la puissance du laser sur sa vitesse de défilement, par rapport à l'épaisseur de la paroi de l'aube, pour la mise en oeuvre de la forme de réalisation préférée du procédé de l'invention ;
- la figure 4 représente une vue en perspective d'une aube rechargée par la forme de réalisation préférée du procédé de l'invention et
- la figure 5 représente une photographie d'une vue en coupe du rechargement de l'aube de la figure 4, avant ré-usinage.

Le dispositif de mise en oeuvre du procédé de rechargement de l'invention, non représenté, comprend principalement une enceinte, une source laser, une buse de projection de poudre, alimentée par un distributeur de poudre et un soufflet de jonction entre le système de focalisation, comprenant notamment la source laser et la buse, et l'enceinte. Le procédé va être décrit pour le rechargement d'une aube de turbine de moteur à turbine à gaz, en alliage à base de nickel, monocristallin ou à solidification dirigée, mais il va de soi qu'il s'applique à toute pièce métallique comportant une paroi à recharger et constituée d'un alliage monocristallin ou à solidification dirigée.

Par monocristallin, on entend un alliage constitué d'un cristal unique. Par solidification dirigée, on entend un alliage dont les cristaux s'étendent tous parallèles les uns aux autres, sous forme de dendrites colonnaires.

L'aube est placée dans l'enceinte, le sommet de sa paroi à recharger vers le haut. L'enceinte est construite en aluminium et se présente sous la forme d'un parallélépipède dont les dimensions sont 130mm * 130mm *100mm. Son volume intérieur est alimenté en argon, afin de créer une atmosphère neutre avec au maximum 200 parties par million (ppm) d'oxygène, pour protéger les divers éléments contre l'oxydation. Un analyseur d'oxygène est agencé dans l'enceinte afin d'assurer une mesure en temps réel de la concentration d'oxygène contenu dans l'enceinte.

L'argon est injecté par six tuyaux placés au sommet de l'enceinte. Dans sa partie inférieure, cette dernière comporte un bac de récupération de poudre métallique qui n'aurait pas été fusionnée pendant le rechargement de la paroi de l'aube. Une fenêtre est percée sur la face avant de l'enceinte afin de pouvoir y placer une caméra, pour suivre le déroulement du procédé, ainsi qu'un pyromètre de contrôle thermique.

L'aube est ici constituée d'un alliage à base de Nickel, que nous dénommerons alliage AM1. Cet alliage est de composition pondérale : Co de 6,0 à 7,0%, Cr de 7,0 à 8,0%, Mo de 1,8 à 2,2%, W de 5,0 à 6,0%, Ta de 7,5 à 8,5%, A1 de 5,1 à 5,5%, Ti de 1,0 à 1,4%, Nb, Mn et Si chacun inférieur à 0,05%, C, B, Cu, P, S, Mg, Sn et Zr chacun inférieur à 0,01%, Hf et Fe chacun inférieur à 0,2% et Ni qui complète à 100%.

La poudre est également en alliage AM1. C'est une poudre sphérique dont les particules sont de diamètre moyen compris entre 25 et 250 µm. Typiquement, pour un sommet de paroi d'aube en alliage AM1, on utilise des particules de diamètre moyen de 63 µm avec un résultat satisfaisant.

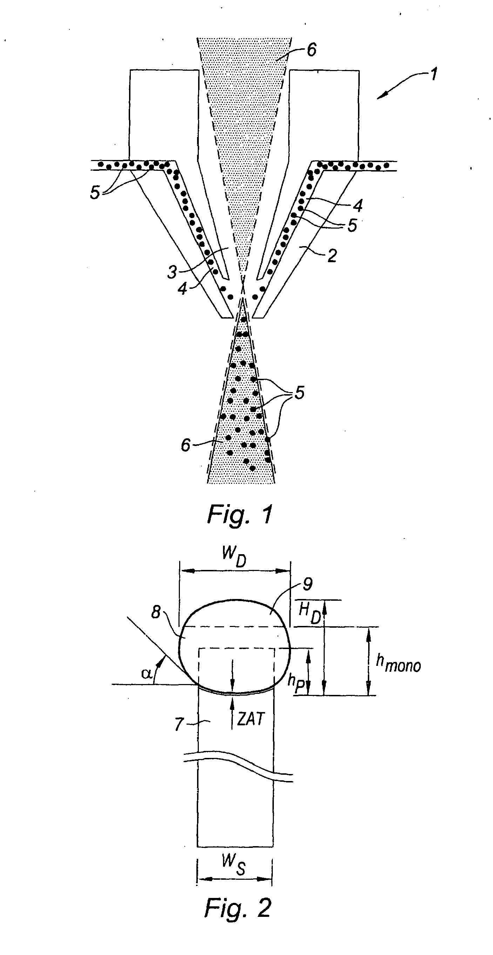

En référence à la figure 1, la buse de projection 1 est disposée au sommet de l'enceinte. Elle comporte une portion d'extrémité tronconique 2 , comprenant un alésage central 3 et une série de canaux antistatiques 4 s'étendant dans la paroi de génération de son extrémité tronconique 2. Les canaux sont alimentés en poudre 5 , tandis qu'un faisceau laser 6 rectiligne se propage au sein de l'alésage central. La buse est du type de la buse décrite dans le brevet DE 3935009, auquel il pourra être fait référence pour plus de détails.

Le faisceau laser 6 est produit par source laser dite YAG. Il s'agit d'un laser dont le milieu laser est constitué d'un Grenat d'Aluminium et Yttrium (YAG), dopé au Néodyme (Nd). Les particules excitables sont les ions néodyme Nd³⁺. Ce laser émet un faisceau de longueur d'onde de 1064 nm. Il émet un faisceau d'énergie continue. La fibre optique de guidage du faisceau est de diamètre 0,3 ou 0,6 mm, en fonction de la géométrie de la paroi à recharger. Par exemple, une fibre de diamètre 0,6 mm permet de recharger des parois dont l'épaisseur est comprise entre 0,5 et 2 mm. Le laser YAG permet une très bonne interaction entre le faisceau laser 6 et la matière, et autorise une plus grande maniabilité de la tête de projection, du fait de la maniabilité de sa fibre optique.

La buse 1 est reliée à un ou des distributeurs de poudre d'alliage AM1. La poudre 5 est entraînée par de l'Argon, afin d'assurer sa protection. Elle est contenue dans un ou des réservoirs dans lesquels elle est brassée de façon à rester homogène. Le débit de gaz dans les distributeurs est de 1 à 2 1/min et celui de la poudre de 6 à 8 g/min. En sortie de la buse de projection 1, le débit de gaz est de 5 à 71/min.

En sortie de la buse 1, le flux de poudre 5 est symétrique et stable afin de pallier toute irrégularité du rechargement ; le faisceau laser 6 se propage de façon coaxiale avec la poudre 5. Cette projection de la poudre 5 dans l'axe du faisceau laser 6 autorise une plus grande maniabilité de la buse de projection 1, mais aussi une plus grande régularité du débit et du phénomène de fusion pour le rechargement.

Le système de focalisation, constitué notamment de la source laser et de la buse 1 , est relié à l'enceinte par un soufflet, dont l'intérieur est en tissu de verre recouvert d'aluminium, afin de supporter les réflexions du faisceau laser 6, et dont l'extérieur comporte une enduction de silicone afin d'être protégé contre d'éventuelles altérations liées aux mouvements de l'ensemble. Il est entraîné en mouvement par un dispositif lui permettant de se déplacer suivant trois directions perpendiculaires et entraîné par un dispositif commandé par un programme.

Le procédé de l'invention va maintenant être décrit plus en détails, en référence aux figures 2 à 5.

Une aube 7 est placée dans l'enceinte du dispositif. La buse 1 est placée au-dessus de la paroi à recharger et projette sur cette dernière le faisceau laser 6 et la poudre 5. Le faisceau laser est émis à une puissance "P" et se déplace le long de la paroi à une vitesse "v". La poudre 5 est projetée dans l'axe du faisceau laser 6.

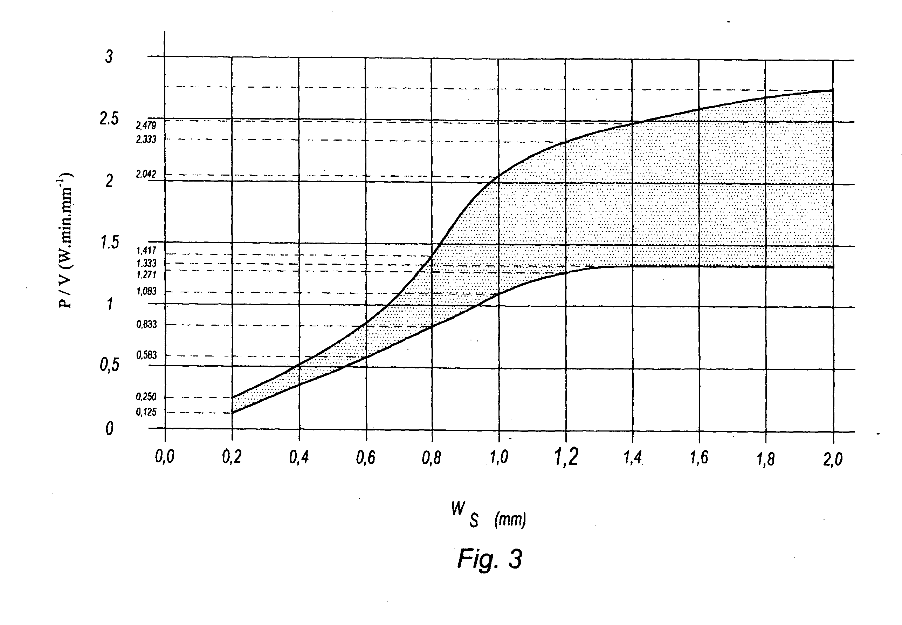

En fonction de l'épaisseur "Wₛ" de la paroi, la demanderesse a découvert qu'il fallait, pour obtenir un rechargement correct, adapter le rapport P/v, en faisant varier l'un ou l'autre des paramètres, de préférence les deux, et a trouvé que l'on pouvait définir une plage de valeurs admises pour ce rapport. La plage des valeurs optimales pour le rapport des paramètres P et v, en fonction de l'épaisseur Wₛ de la paroi est définie sur la courbe de la figure 3.

En première approximation par portions de courbes, on voit que le rapport P/v doit être compris :
- pour une épaisseur Wₛ comprise entre 0,2 et 0,6 mm, entre deux portions de courbes croissantes, l'une prenant des valeurs allant de 0,12, de préférence 0,125, à 0,58, de préférence 0,583 W.min.mm⁻¹, l'autre prenant des valeurs allant de 0,25 à 0,84, de préférence 0,833 W.min.mm⁻¹ ;
- pour une épaisseur Wₛ comprise entre 0,6 et 0,8 mm, entre deux portions de courbes croissantes, l'une prenant des valeurs allant de 0,58, de préférence 0,583, à 0,83, de préférence 0,833 W.min.mm⁻¹, l'autre prenant des valeurs allant de 0,84, de préférence 0,833, à 1,42, de préférence 1,417 W.min.mm⁻¹ ;
- pour une épaisseur Wₛ comprise entre 0,8 et 1 mm, entre deux portions de courbes croissantes, l'une prenant des valeurs allant de 0,83, de préférence 0,833, à 1,08, de préférence 1,083 W.min.mm⁻¹, l'autre prenant des valeurs allant de 1,42, de préférence 1,417, à 2,05, de préférence 2,042 W.min.mm⁻¹ ;
- pour une épaisseur Wₛ comprise entre 1 et 1,2 mm, entre deux portions de courbes croissantes, l'une prenant des valeurs allant de 1,08, de préférence 1,083, à 1,27, de préférence 1,271 W.min.mm⁻¹, l'autre prenant des valeurs allant de 2,05, de préférence 2,042, à 2,34, de préférence 2,333 W.min.mm⁻¹ ;
- pour une épaisseur Wₛ comprise entre 1,2 et 1,4 mm, entre deux portions de courbes croissantes, l'une prenant des valeurs allant de 1,27, de préférence 1,271, à 1,33, de préférence 1,333 W.min.mm-1, l'autre prenant des valeurs allant de 2,34, de préférence 2,333, à 2,48, de préférence 2,479 W.min.mm⁻¹ ;
- pour une épaisseur Wₛ comprise entre 1,4 et 2 mm, entre deux portions de courbes croissantes, l'une constante égale à 1, 33, de préférence 1,333 W.min.mm⁻¹, l'autre prenant des valeurs allant de 2,48, de préférence 2,479, à 2,75 W.min.mm⁻¹.

En première approximation, les courbes définissant la plage qu'a découvert la demanderesse ont été définies par portions de courbes croissantes. Ces dernières ont un comportement tangentiel que l'on qualifiera de "lisse", c'est-à-dire que les courbes évoluent d'une façon assez régulière d'une portion de courbe à l'autre, sans changement brusque de concavité par exemple. Une méthode pour tracer les courbes à partir des données que l'on a donné est, pour aller d'un premier point à un deuxième, d'anticiper sur le point qui suivra le deuxième pour ne pas avoir à opérer de changement non logique de concavité.

Une autre approximation peut être de prendre des portions de droits pour les portions de courbes définies ci-dessus.

Ainsi, tout en respectant la plage définie sur la figure 3, on asservit le rapport P/v à l'épaisseur Wₛ de la paroi. Cet asservissement peut être assuré par un programme. L'évolution de l'épaisseur Wₛ de la paroi de l'aube 7 est préalablement déterminée et rentrée dans le programme. Lors de la mise en oeuvre du procédé, ce programme commande l'évolution du rapport P/v en fonction de la position de la buse 1 le long de la paroi, et donc de l'épaisseur Wₛ de cette dernière, en fonction de paramètres définis par l'utilisateur, par exemple le diamètre de la fibre optique, la géométrie que l'on veut donner au cordon de rechargement, la hauteur de la couche que l'on veut créer, ... tout en restant dans la plage définie par la figure 3.

Une autre possibilité est de mettre en place un dispositif auto-régulateur qui commande le rapport P/v en temps réel en fonction d'une donnée, qui peut être la mesure de la luminosité du bain fondu, qui dépend, indirectement, de l'épaisseur Wₛ de la paroi à un point donné. Cette mesure peut être assurée par une photodiode reliée à un système de contrôle.

En maintenant le rapport P/v dans la plage définie, l'action du faisceau laser 6 sur la poudre 5 projetée sur la paroi entraîne la fusion de la poudre et la croissance d'un alliage ; cette croissance se fait de façon colonnaire épitaxiale à partir des bras primaires des dentrites contenus dans le substrat, c'est-à-dire le sommet de l'aube 7, et a pour conséquence la solidification d'un métal monocristallin ou à solidification dirigée, selon la nature du substrat.

On voit sur la figure 2 la construction de la première couche métallique 8. Les divers paramètres sont réglés de façon à fusionner le substrat sur une hauteur hp et ainsi permettre la solidification de la nouvelle couche à partir des bras primaires de ses dentrites. La poudre 5 est projetée de façon à obtenir une couche 8 de hauteur H_{D}. Cette couche 8 est formée de façon à avoir un profil de goutte, dont l'angle α à la base doit être compris entre 30 et 70°, afin que l'usinage après le procédé, appelé ré-usinage, pour ré-obtenir une paroi rectiligne, soit minimum. La largeur maximal W_{D} de la goutte doit être comprise entre 110 et 150 % de la largeur Wₛ de l'aube 7, afin de limiter le ré-usinage.

La hauteur hₘₒₙₒ représente la hauteur, à partir du substrat non fusionné, sur laquelle la goutte présente une structure de solidification monocristalline ou à solidification dirigée. Au-dessus de cette hauteur, la calotte 9 de hauteur (H_{D} ― hₘₒₙₒ) n'est pas convenablement solidifiée et devra être fusionnée lors de l'application de la seconde couche, afin que cette dernière puisse se faire à partir des bras primaires des dendrites colonnaires de la première couche 8, et ainsi de suite pour chacune des couches.

Grâce au procédé de l'invention et au bon choix du rapport P/v, la zone affectée thermiquement, symbolisée par les flèches ZAT sur la figure 2, sera minimale.

Afin de recharger le sommet de l'aube 7, plusieurs couches doivent être construites. Le procédé peut être mis en oeuvre, en ce qui concerne la succession des couches, selon différentes formes de réalisation, dont deux vont maintenant être décrites.

Dans une première forme de réalisation, l'énergie déposée à la première couche 8, dépendant de l'épaisseur Wₛ de la paroi de l'aube 7 au fur et à mesure de l'avancée de la buse 1 le long de cette paroi, est la même que celle qui est déposée aux couches suivantes. Cette forme de réalisation est la plus simple car un seul programme de puissance est nécessaire pour sa mise en oeuvre.

Dans une seconde forme de réalisation, l'énergie déposée à la première couche 8 est minimalisée, de façon à fusionner au minimum le substrat, puis l'énergie des couches suivantes est la même pour chacune d'entre elles, égale à celle de la première couche 8 augmentée de 10 à 20 %. Pour l'ensemble des couches, sauf la première couche 8, le rapport P/v prend les mêmes valeurs le long de la paroi de l'aube 7.

Entre la formation de chaque couche, l'aube 7 sera de préférence refroidie à une température inférieure à 600°.

En outre, avant la fabrication de la première couche 8, il est possible de préchauffer le substrat, comme cela était couramment fait dans l'art antérieur. Dans ce cas, le préchauffage peut être assuré par le faisceau laser 6 lui-même, qui peut effectuer une première série de passages au-dessus de la paroi de l'aube 7, sans projeter de poudre. En jouant sur la focalisation du laser, on peut garantir un chauffage homogène. Le nombre de passage et l'énergie apportée seront dimensionnés de façon à garantir un préchauffage minimal mais suffisant pour limiter la fissuration. Il peut être envisagé d'asservir le système par une mesure de température qui, lorsque la consigne température est atteinte, stoppe la phase de préchauffage.

Le procédé de l'invention permet sinon, grâce à la qualité du choix de ses paramètres, notamment les paramètres P et v, d'effectuer le rechargement de la paroi de l'aube 7 sans préchauffage, ce qui permet un gain de temps et une simplification du procédé considérables.

Un traitement thermique post-opératoire est préférablement effectué une fois l'ensemble des couches construites, afin d'homogénéiser leur structure et de permettre une relaxation des contraintes résiduelles. Ce traitement sera fait de préférence entre 800 et 1300°C.

A titre d'exemple, pour une épaisseur Wₛ égale à 1 mm, on peut choisir une puissance P = 400 W, avec une vitesse v = 250 mm/min, pour la première couche 8, et une puissance P = 500 W, avec une vitesse v = 300 mm/min, pour toutes les autres couches, par exemple neuf autre couches. On voit que les rapports P/v sont bien contenus dans la plage de la figure 3 pour l'épaisseur Wₛ = 1 mm.

Pour une épaisseur Wₛ égale à 0,5 mm, on peut choisir une puissance P = 125 W, avec une vitesse v = 250 mm/min, pour la première couche 8, et une puissance P = 150 W, avec une vitesse v = 250 mm/min, pour toutes les autres couches.

On peut aussi choisir, pour cette même épaisseur, une puissance P = 150 W, avec une vitesse v = 250 mm/min, pour la première couche 8, et une puissance P = 175 W, avec une vitesse v = 250 mm/min, pour toutes les autres couches.

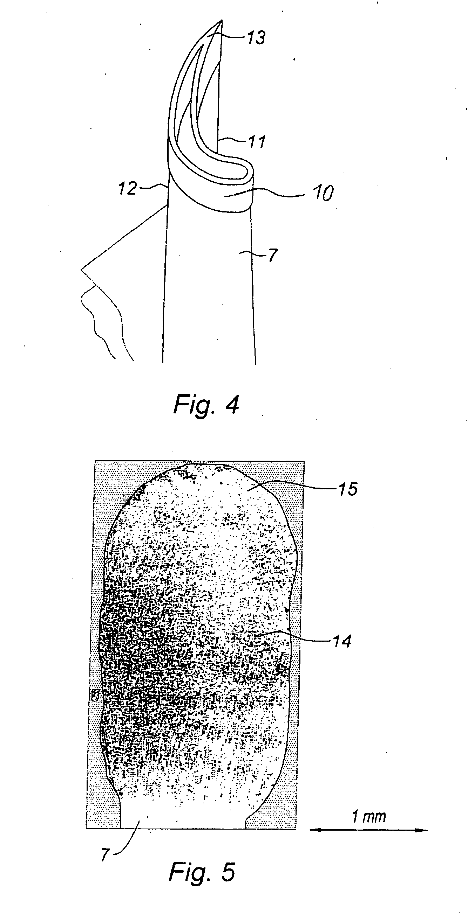

On voit sur la figure 4 l'aube 7 une fois le procédé de l'invention terminé, le traitement thermique post-opératoire et le ré-usinage effectués. On distingue le rechargement 10 obtenu, qui prolonge la paroi de l'aube 7 sur l'intrados 11, l'extrados 12 et le bord de fuite 13. Les épaisseurs Wₛ de ces différentes parois ne sont pas constantes et le procédé de l'invention permet d'asservir le rapport P/v à leur évolution, tout en assurant la bonne qualité du rechargement.

On voit sur la figure 5 une photographie en coupe du rechargement 14 de la paroi de l'aube 7 avant son ré-usinage. On voit bien que la structure interne de ce rechargement est dendritique colonnaire, à l'exception de sa calotte supérieure 15. Il est clair sur cette figure que deux objectifs sont à prendre en compte lors de la définition des paramètres opératoires : l'obtention d'une microstructure acceptable, monocristalline ou à solidification dirigée, mais aussi l'obtention d'une bonne géométrie pour la goutte (par exemple, si le procédé est effectué trop lentement, la goutte risque de s'affaisser et de ne pas présenter une géométrie correcte).

Ainsi, l'invention permet la mise en place d'un procédé tout à fait optimisé. Le choix est donné à l'homme du métier d'utiliser ou non un préchauffage, selon les contraintes auxquelles il est astreint. Le fait de ne pas l'utiliser, si les contraintes sont assez souples, procure un gain de temps et une simplification du procédé non négligeables. Le fait de l'utiliser offre des résultats plus précis et plus sûrs.

La plage de paramètres qui a été définie assure à l'homme du métier la formation d'un rechargement dont la solidification se fait de manière colonnaire et épitaxiée avec les dendrites des bras primaires du substrat, afin d'obtenir un rechargement monocristallin ou à solidification dirigée et d'une forme géométrique permettant un ré-usinage.

La zone affectée thermiquement dans le cadre du procédé est moins étendue que dans l'art antérieur.

L'utilisation d'un laser YAG avec une buse coaxiale assure une meilleure interaction laser ― matière, une plus grande maniabilité de la tête de projection et une souplesse d'utilisation de la fibre optique accrue.

L'invention a été décrite en relation avec un alliage monocristallin AM1, mais elle s'applique à d'autres types de métaux.

## Revendications

1. Procédé de rechargement d'une pièce (7) métallique monocristalline ou à solidification dirigée, d'épaisseur (Wₛ) inférieure à 2 mm, dans lequel on applique un faisceau laser (6) et un flux de poudre métallique (5), dont la nature est la même que celle de la pièce métallique, sur la pièce (7) pour fabriquer au moins une couche de métal, monocristalline ou à solidification dirigée, à partir de la pièce (7), le faisceau laser (6) étant émis à une puissance "P" et se déplaçant le long de la pièce à une vitesse "v", **caractérisé par le fait que** le faisceau laser (6) et le flux de poudre (5) sont appliqués de façon coaxiale sur la pièce (7) et le rapport P/v est compris :
- pour une épaisseur Wₛ comprise entre 0,2 et 0,6 mm, entre deux portions de courbes croissantes, l'une prenant des valeurs allant de 0,12, de préférence 0,125, à 0,58, de préférence 0,583 W.min.mm⁻¹, l'autre prenant des valeurs allant de 0,25 à 0,84, de préférence 0,833 W.min.mm⁻¹;
- pour une épaisseur Wₛ comprise entre 0,6 et 0,8 mm, entre deux portions de courbes croissantes, l'une prenant des valeurs allant de 0,58, de préférence 0,583, à 0,83, de préférence 0,833 W.min.mm⁻¹, l'autre prenant des valeurs allant de 0,84, de préférence 0,833, à 1,42, de préférence 1,417 W.min.mm⁻¹;
- pour une épaisseur Wₛ comprise entre 0,8 et 1 mm, entre deux portions de courbes croissantes, l'une prenant des valeurs allant de 0,83, de préférence 0,833, à 1,08, de préférence 1,083 W.min.mm⁻¹, l'autre prenant des valeurs allant de 1,42, de préférence 1,417, à 2,05, de préférence 2,042 W.min.mm⁻¹;
- pour une épaisseur Wₛ comprise entre 1 et 1,2 mm, entre deux portions de courbes croissantes, l'une prenant des valeurs allant de 1,08, de préférence 1,083, à 1,27, de préférence 1,271 W.min.mm⁻¹, l'autre prenant des valeurs allant de 2,05, de préférence 2,042, à 2,34, de préférence 2,333 W.min.mm⁻¹;
- pour une épaisseur Wₛ comprise entre 1,2 et 1,4 mm, entre deux portions de courbes croissantes, l'une prenant des valeurs allant de 1,27, de préférence 1,271, à 1,33, de préférence 1,333 W.min.mm⁻¹, l'autre prenant des valeurs allant de 2,34, de préférence 2,333, à 2,48, de préférence 2,479 W.min.min⁻¹;
- pour une épaisseur Wₛ comprise entre 1,4 et 2 mm, entre deux portions de courbes croissantes, l'une constante égale à 1, 33, de préférence 1,333 W.min.mm⁻¹, l'autre prenant des valeurs allant de 2,48, de préférence 2,479, à 2,75 W.min.mm⁻¹.

2. Procédé selon la revendication 1, dans lequel les portions de courbes sont des portions de droites.

3. Procédé selon l'une des revendications 1 ou 2, dans lequel, avant d'appliquer le flux de poudre (5), on effectue un préchauffage de la pièce (7).

4. Procédé selon la revendication 3, dans lequel le préchauffage est effectué par le faisceau laser (6).

5. Procédé selon l'une des revendications 1 ou 2, dans lequel l'application du flux de poudre (5) est effectuée sans préchauffage de la pièce (7).

6. Procédé selon l'une des revendications 1 à 5 dans lequel, plusieurs couches de métal étant successivement fabriquées, l'énergie appliquée le long de la pièce à toutes les couches est la même.

7. Procédé selon l'une des revendications 1 à 5 dans lequel, plusieurs couches de métal étant successivement fabriquées, l'énergie de la première couche (8) est inférieure à l'énergie des couches suivantes.

8. Procédé selon l'une des revendications 6 ou 7, dans lequel le rapport P/v des couches auxquelles est appliquée la même énergie est égal.

9. Procédé selon l'une des revendications 1 à 8, dans lequel la pièce (7) et la poudre (5) comprennent un alliage à base de nickel du type dit AM1.

10. Procédé selon l'une des revendications 1 à 9, dans lequel le faisceau laser (6) est un faisceau laser YAG.

11. Procédé selon l'une des revendications 1 à 10, dans lequel le faisceau laser (6) et la poudre métallique (5) sont appliqués par une buse de projection (1), comprenant une portion d'extrémité tronconique (2) qui comporte un alésage central (3) de passage du faisceau laser (6) et des canaux (4), s'étendant dans la paroi de génération de son extrémité tronconique (2), d'alimentation en poudre (5).

12. Procédé selon l'une des revendications 1 à 11, dans lequel la pièce (7) est une aube de moteur à turbine à gaz.

## Claims

1. A process for resurfacing a monocrystalline or directionally solidified metallic piece (7), of a thickness (Wₛ) less than 2 mm, wherein a laser beam (6) and a flux of metallic powder (5), whereof the nature is the same as that of the metallic piece, are applied to the piece (7) to produce at least one layer of metal, monocrystalline or directionally solidified, from the piece (7), the laser beam (6) being sent out at a power "P" and moving along the piece at a speed "v", **characterised in that** the laser beam (6) and the flux of powder (5) are applied coaxially on the piece (7) and the P/v ratio is:
- for a thickness Wₛ between 0.2 and 0.6 mm, between two portions of increasing curves, one taking values ranging from 0.12, preferably 0.125, to 0.58, preferably 0.583 W.min.mm⁻¹, the other taking values ranging from 0.25 to 0.84, preferably 0.833 W.min.mm⁻¹;
- for a thickness Wₛ between 0.6 and 0.8 mm, between two portions of increasing curves, one taking values ranging from 0.58, preferably 0.583, to 0.83, preferably 0.833 W.min.mm⁻¹, the other taking values ranging from 0.84, preferably 0.833, to 1.42, preferably 1.417 W.min.mm⁻¹;
- for a thickness Wₛ between 0.8 and 1 mm, between two portions of increasing curves, one taking values ranging from 0.83, preferably 0.833, to 1.08, preferably 1.083 W.min.mm⁻¹, the other taking values ranging from 1.42, preferably 1.417, to 2,05, preferably 2.042 W.min.mm⁻¹;
- for a thickness Wₛ between 1 and 1.2 mm, between two portions of increasing curves, one taking values ranging from 1.08, preferably 1.083, to 1.27, preferably 1.271 W.min.mm⁻¹, the other taking values ranging from 2.05, preferably 2.042, to 2.34, preferably 2.333 W.min.mm⁻¹;
- for a thickness Wₛ between 1.2 and 1.4 mm, between two portions of increasing curves, one taking values ranging from 1.27, preferably 1.271, to 1.33, preferably 1.333 W.min.mm⁻¹, the other taking values ranging from 2.34, preferably 2.333, to 2.48, preferably 2.479 W.min.mm⁻¹;
- for a thickness Wₛ between 1.4 and 2 mm, between two portions of increasing curves, the constant one equal to 1.33, preferably 1.333 W.min.mm⁻¹, the other taking values ranging from 2.48, preferably 2.479, to 2.75 W.min.mm⁻¹.

2. The process as claimed in Claim 1, in which the portions of curves are portions of straight lines.

3. The process as claimed in any one of Claims 1 or 2, in which pre-heating of the piece (7) is carried out prior to application of the flux of powder (5).

4. The process as claimed in Claim 3, in which the pre-heating is carried out by laser beam (6).

5. The process as claimed in any one of Claims 1 or 2, in which the application of the flux of powder (5) is carried out without pre-heating of the piece (7).

6. The process as claimed in any one of Claims 1 to 5, in which several layers of metal being successively fabricated, the energy applied along the piece to all the layers is the same.

7. The process as claimed in any one of Claims 1 to 5, wherein several layers of metal are successively produced and the energy of the first layer (8) is less than the energy of the subsequent layers.

8. The process as claimed in any one of Claims 6 or 7, wherein the P/v ratio of the layers to which the same energy is applied is equal.

9. The process as claimed in any one of Claims 1 to 8, wherein the piece (7) and the powder (5) comprise a nickel-based alloy known as AM1.

10. The process as claimed in any one of Claims 1 to 9, wherein the laser beam (6) is a YAG laser beam.

11. The process as claimed in any one of Claims 1 to 10, wherein the laser beam (6) and the metallic powder (5) are applied by a projection nozzle (1), comprising a truncated end portion (2) which comprises a central bore (3) for passage of the laser beam (6) and channels (4), extending in the generation wall of its truncated end (2), for supplying the powder (5).

12. The process as claimed in any one of Claims 1 to 11, in which the piece (7) is a gas turbine motor blade.

## Patentansprüche

1. Verfahren zum Wiederaufbauen eines Bauteils (7) aus einkristallinem oder gerichtet erstarrtem Metall mit einer Dicke (Wₛ) von weniger als 2 mm, in dem ein Laserstrahl (6) und ein metallisches Schweißpulver (5), dessen Beschaffenheit die gleiche wie diejenige des Metallbauteils ist, auf das Bauteil (7) angewendet wird, um mindestens eine Schicht aus einkristallinem oder gerichtet erstarrtem Metall aus dem Bauteil (7) herzustellen, wobei der Laserstrahl (6) mit einer Leistung "P" emittiert wird und sich entlang des Bauteils mit einer Geschwindigkeit "v" fortsetzt, **dadurch gekennzeichnet, dass** der Laserstrahl (6) und das Schweißpulver (5) koaxial auf das Bauteil (7) angewendet werden und das Verhältnis P/v einschließt:
- für eine Dicke Wₛ zwischen 0,2 und 0,6 mm, zwischen zwei Abschnitten von ansteigenden Kurven, wobei der eine Werte von 0,12, vorzugsweise 0,125 bis 0,58, vorzugsweise 0,583 W.min.mm⁻¹, der andere Werte von 0,25 bis 0,84, vorzugsweise 0,833 W.min.mm⁻¹ annimmt;
- für eine Dicke Wₛ zwischen 0,6 und 0,8 mm, zwischen zwei Abschnitten von ansteigenden Kurven, wobei der eine Werte von 0,58, vorzugsweise 0,583 bis 0,83, vorzugsweise 0,833 W.min.mm⁻¹, der andere Werte von 0,84, vorzugsweise 0,833 bis 1,42, vorzugsweise 1,417 W.min.mm⁻¹ annimmt;
- für eine Dicke Wₛ zwischen 0,8 und 1 mm, zwischen zwei Abschnitten von ansteigenden Kurven, wobei der eine Werte von 0,83, vorzugsweise 0,833 bis 1,08, vorzugsweise 1,083 W.min.mm⁻¹, der andere Werte von 1,42, vorzugsweise 1,417 bis 2,05, vorzugsweise 2,042 W.min.mm⁻¹ annimmt;
- für eine Dicke Wₛ zwischen 1 und 1,2 mm, zwischen zwei Abschnitten von ansteigenden Kurven, wobei der eine Werte von 1,08. vorzugsweise 1,083 bis 1,27, vorzugsweise 1,271 W.min.mm⁻¹, der andere Werte von 2,05, vorzugsweise 2,042 bis 2,34, vorzugsweise 2,333 W.min.mm⁻¹ annimmt;
- für eine Dicke Wₛ zwischen 1,2 und 1,4 mm, zwischen zwei Abschnitten von ansteigenden Kurven, wobei der eine Werte von 1,27, vorzugsweise 1,271 bis 1,33, vorzugsweise 1,333 W.min.mm⁻¹, der andere Werte von 2,34, vorzugsweise 2,333 bis 2,48, vorzugsweise 2,479 W.min.mm⁻¹ annimmt;
- für eine Dicke Wₛ zwischen 1,4 und 2 mm, zwischen zwei Abschnitten von ansteigenden Kurven, wobei der eine konstant gleich 1,33, vorzugsweise 1,333 W.min.mm⁻¹ ist, der andere Werte von 2,48, vorzugsweise 2,479 bis 2,75 W.min.mm⁻¹ annimmt.

2. Verfahren nach Anspruch 1, wobei die Kurvenabschnitte Abschnitte von Geraden sind.

3. Verfahren nach einem der Ansprüche 1 oder 2, wobei vor der Anwendung des Schweißpulvers (5) eine Vorerwärmung des Bautels (7) erfolgt.

4. Verfahren nach Anspruch 3, wobei die Vorerwärmung durch den Laserstrahl (6) erfolgt.

5. Verfahren nach einem der Ansprüche 1 oder 2, wobei die Anwendung des Schweißpulvers (5) ohne Vorerwärmung des Bauteils (7) erfolgt.

6. Verfahren nach einem der Ansprüche 1 bis 5, wobei mehrere Metallschichten aufeinander folgend hergestellt werden und die Energie, die entlang des Bauteils auf alle Schichten angewendet wird, die gleiche ist.

7. Verfahren nach einem der Ansprüche 1 bis 5, wobei mehrere Metallschichten aufeinander folgend hergestellt werden und die Energie der ersten Schicht (8) geringer als die Energie der folgenden Schichten ist.

8. Verfahren nach einem der Ansprüche 6 oder 7, wobei das Verhältnis P/v der Schichten, auf die die gleiche Energie angewendet wird, gleich ist.

9. Verfahren nach einem der Ansprüche 1 bis 8, wobei das Bauteil (7) und das Pulver (5) eine Legierung auf der Grundlage von Nickel des Typs mit der Bezeichnung AMI umfassen.

10. Verfahren nach einem der Ansprüche 1 bis 9, wobei der Laserstrahl (6) ein YAG-Laserstrahl ist.

11. Verfahren nach einem der Ansprüche 1 bis 10, wobei der Laserstrahl (6) und das Metallpulver (5) durch eine Strahldüse (1) angewendet werden, umfassend einen Abschnitt mit einem kegelstumpfartigen Ende (2), der eine zentrale Bohrung (3) zum Durchgang des Laserstrahls (6) aufweist, sowie Kanäle (4), die sich in der Wand des Ausgangs ihres kegelstumpfartigen Endes (2) erstrecken, zur Versorgung mit Pulver (5).

12. Verfahren nach einem der Ansprüche 1 bis 11, wobei das Bauteil (7) eine Motorschaufel mit Gasturbine ist.
